# EUROPEAN PATENT APPLICATION

(11) **EP 4 340 006 A1**
(43) Date of publication of application: **20.03.2024**
(21) Application number: 22195765.7
(22) Date of filing: 15.09.2022
(51) Int. Cl.: H01L 21/67

(54) **COOLING STAGE FOR COOLING DOWN A HEATED CARRIER**

(71) Applicant: Nexperia B.V., 6534 AB Nijmegen (NL)
(72) Inventor: de Roest, Arne, 6534AB Nijmegen (NL); Hanegraaf, Roland, 6534AB Nijmegen (NL); Houben, Patrick, 6534AB Nijmen (NL)
(74) Representative: Pjanovic, Ilija

(57) **Abstract**

Aspects of the present disclosure relate to a cooling stage for cooling down a heated carrier on which a plurality of components has been mounted. Further aspects of the present disclosure relate to a pick-and-place apparatus that comprises such cooling stage and to a method for cooling down a heated carrier on which a plurality of components has been mounted.

The cooling stage according to an aspect of the present disclosure uses supporting members for keeping the heated carrier separated from a cooling body.

By relying on thermal convection between the heated carrier and the cooling body, dependency of the cooling stage on the type of carrier used is reduced compared to known cooling stages. For example, for different types of carries, it generally suffices to use different supporting members, e.g. having a different height, and/or to use a different temperature of the cooling body.

## Description

### FIELD

Aspects of the present disclosure relate to a cooling stage for cooling down a heated carrier on which a plurality of components has been mounted. Further aspects of the present disclosure relate to a pick-and-place apparatus that comprises such cooling stage and to a method for cooling down a heated carrier on which a plurality of components has been mounted.

### BACKGROUND

Known apparatuses for mounting semiconductor dies are hereinafter referred to as pick-and-place apparatuses. These apparatuses comprise a heating stage for heating a carrier, such as a lead-frame, a pick-and-place unit for picking an electrical component, such as a semiconductor die, and for placing the picked electrical component on the heated carrier. The known pick-and-place apparatuses further comprise a cooling stage for cooling down the heated carrier after the electrical components have been arranged on the heated carrier.

In high-volume chip bond solder processes, in which semiconductor dies are mounted on a lead-frame, an inherent conflict exists between a high equipment throughput requirement and a low cooling rate requirement to prevent die cracks. At too steep a cooling rates, mechanical stress due to the mismatch in thermal expansion coefficients (CTE) of the semiconductor chip and metal lead-frame leads to die cracks. A low cooling rate requirement depends on the carrier material and the carrier design parameters like the product pitch. It conflicts with a desired short carrier index time and a simple, low-cost heating stage construction.

In current heating stage concepts for die bonding, the lead-frame temperature rises from ambient to a die bond process temperature at which the semiconductor chip is bonded. After bonding, the lead-frame needs to cool down in the cooling stage to ambient temperatures again, following a pre-defined temperature curve over time. The product pitch and throughput combined with the temperature in the heating stage define the cooling rate.

For example, in a eutectic Silicon chip bonding process occurring between 410 and 450 degrees Celsius, the linear cooling rates are defined as less than 25 degrees Celsius per second for full Copper lead-frames and less than 50 degrees Celsius per second for Nickel-Iron alloy lead-frames.

In the known cooling stages, cooling zones are controlled at different temperatures to approach the prescribed linear cooling rate. Heat flows through the mechanical construction by thermal conduction and then to the environment by (free) air convection. In this contact heating concept, the cooling rate is product specific, because it depends on the material and index speed of the lead-frame. Therefore, for each product, the temperature settings need to be tuned and stored in the related process program.

Because of a desired higher equipment throughput, the cooling of each lead-frame type requires a different cooling rate which normally means that the cooling stage in the pick-and-place apparatus must be relatively long.

### SUMMARY

Aspects of the present disclosure relate to a cooling stage for cooling down a heated carrier on which a plurality of components has been mounted that has a more limited dependency on the type of carrier that is used. More in particular, aspects of the present disclosure relate to a cooling stage wherein process settings, temperature profiles and mechanical parts remain the same as much as possible.

To that end, a cooling stage is provided that comprises a cooling body, a cooling unit for controlling a temperature of the cooling body, and a plurality of supporting members configured for supporting the heated carrier and for keeping the cooling body and heated carrier spaced apart.

The thermal conductivity of the plurality of supporting members, the thermal conductivity of the cooling body, the temperature of the cooling body, and the spacing between the cooling body and the heated carrier is configured to ensure that during operation cooling of the heated carrier is predominantly obtained through thermal convection between the heated carrier and the cooling body.

By relying on thermal convection between the heated carrier and the cooling body, dependency of the cooling stage on the type of carrier used is reduced compared to known cooling stages. For example, for different types of carriers, it generally suffices to use different supporting members, e.g. having a different height, and/or to use a different temperature of the cooling body.

The cooling stage may further comprise a conveying unit for conveying the heated carrier along a path from a start of the cooling stage to an end of the cooling stage, wherein the conveying unit is preferably configured to intermittently convey the heated carrier. The conveying unit may in some embodiments be a passive unit in the sense that it only guides the carrier as it moves through the cooling stage. In other embodiments, the conveying unit comprises a drive by which the carrier is moved through the cooling stage.

The cooling stage can be configured to cool down the heated carrier during a first cooling step and a second cooling step following the first cooling step, wherein an average distance between the heated carrier and the cooling body is larger during the first cooling step than during the second cooling step. The present disclosure is not limited to two cooling steps and more cooling steps may be used if so required. A higher average distance results in a higher effective thermal resistance between the heated carrier and the cooling body thereby limiting the cooling rate during the first cooling step. During the second cooling step, in which the heated carrier has already cooled down, a smaller average distance and therefore lower thermal resistance can be used while still ensuring that the cooling rate stays within limits.

In some embodiments, during the first cooling step, the distance between the heated carrier and the cooling body may decrease in a first direction from a start of the cooling stage to an end of the cooling stage, wherein during the second cooling step, the distance between the heated carrier and the cooling body preferably remains substantially constant in said first direction. By varying the distance in the first cooling stage it becomes possible to compensate for a temperature gradient over the heated carrier that may exist prior to the heated carrier being cooled by the cooling stage. For example, a first end of the heated carrier closest to the cooling stage may have a lower temperature prior to being cooled by the cooling stage than the opposite second end of the heated carrier. To ensure a similar cooling rate between the first and second ends, a smaller distance between heated carrier and cooling body can be used for the first end than for the second end.

The cooling stage may comprise a first section and a second section arranged downstream of the first section, wherein the conveying unit is configured for positioning the heated carrier in the first section during the first cooling step and for positioning the heated carrier in the second section during the second cooling step.

The conveying unit can be configured to receive a next heated carrier when transferring the heated carrier from the first section to the second section, and to output a heated carrier that was previously arranged in the second section. In this manner, a continuous flow of heated carriers can be handled. In each of the first section and second section, the heated carrier will generally be stationary for a given amount of time to allow proper cooling. When the corresponding cooling step is finished, the heated carrier in the first section is transported to the second section, the heated carrier in the second section is outputted, and a next heated carrier is positioned in the first section.

The plurality of supporting members can be fixedly connected to the cooling body. Furthermore, a height in the first section of the plurality of supporting members in a second direction perpendicular to said first direction preferably decreases along the path while at the same time an upper surface of the cooling body by which the cooling body is connected to the supporting members is inclined relative to the heated carrier to compensate for the decreasing height of the supporting members.

Alternatively, the cooling body can be movable relative to the supporting members. For example, the plurality of supporting members can be fixedly connected to the conveying unit such that a conveying action of the conveying unit is imparted on the heated carrier via the supporting members. In other embodiments, the supporting members are stationary, and the cooling body may move. For example, the cooling stage may further comprise a drive for moving the cooling body relative to the supporting members. In this case, the cooling stage preferably further comprises a controller for controlling the drive. This controller can be configured to control the drive to translate the cooling body, and the controller is preferably further configured for controlling the drive to rotate the cooling body around a rotation axis. By moving the cooling body relative to the supporting members and therefore relative to the heated carrier supported by the supporting members, it becomes possible to change the distance between the heated carrier and the cooling body without moving the heated carrier. Hence, in these embodiments, there is no transfer needed of the heated carrier between the first and second cooling steps. The conveying unit can therefore be configured to maintain a same position of the heated carrier during the first cooling step and second cooling step although the present disclosure is not limited thereto. Furthermore, the controller can preferably be configured to control the drive to position the cooling body in a first position and first orientation relative to the heated carrier during the first cooling step, and to position the cooling body in a second position and second orientation relative to the heated carrier during the second cooling step. For example, the first position corresponds to a higher distance between the heated carrier and cooling body than the second position. Moreover, the first orientation may correspond to an inclined position of the cooling body relative to the heated carrier, whereas the second orientation corresponds to a parallel position of the cooling body relative to the heated carrier. It is noted that the heated carrier is generally a flat structure.

The cooling body may comprise slots through which the supporting members extend. The cooling body may comprise a plurality of cooling body parts, wherein, in so far as being applicable, the controller is configured to control the drive for individually moving the cooling body parts. For example, the cooling stage may comprise the abovementioned first and second section. By using two movable cooling body parts, one for each section, it is possible to account for a change in type of heated carrier by using a different position and orientation of the heated carrier. Accordingly, there is little need for changing the supporting members when handling different types of heated carriers.

The cooling body may comprise a plate member, and the cooling unit may comprise one or more ducts carrying a coolant for cooling the plate member. The one or more ducts can be at least partially integrated in or connected to the plate member. The cooling unit can be configured to control a temperature of the cooling body to be within a predefined range. For example, one or more temperature sensors may be mounted to the cooling body, and the cooling unit can be configured for controlling the temperature of the cooling body in dependence of a temperature measured by the one or more temperature sensors.

The heated carrier may comprise a heated lead-frame although other carriers such as printed circuit boards, PCBs, substrates, Polyethylene terephthalate foils, or metal straps, are not excluded. The plurality of electrical components may comprise a plurality of bare or packaged semiconductor dies, although other electrical components such as surface mounted device are not excluded. A temperature of the heated carrier prior to cooling by the cooling stage may lie in a range between 150 and 450 degrees Celsius, and/or a temperature of the cooling body during operation may be substantially constant, said substantially constant temperature preferably lying in a range between 18 and 35 degrees Celsius.

The cooling stage may comprise a further cooling body that is arranged at an opposite side of the heated carrier as the cooling body, wherein the cooling stage preferably comprises further supporting members extending between the further cooling body and the heated carrier. Typically, the cooling body is arranged below the heated carrier. It is therefore also possible to arrange an additional cooling body, i.e. the further cooling body, above the heated carrier. Optionally, further supporting members may extend between this further cooling body and the heated carrier. It is noted that the further cooling body and/or the further supporting members can be configured as the cooling body and supporting members as defined above, respectively.

According to a further aspect of the present disclosure, a pick-and-place apparatus is provided that comprises a heating stage for heating a carrier, a pick-and-place unit for picking an electrical component and for placing the picked electrical component on the heated carrier, and the cooling stage as described above for cooling down the heated carrier. It should be noted that the cooling stage described above could equally be used in other devices or systems such as curing stations.

According to an even further aspect of the present disclosure, a method for cooling down a heated carrier on which a plurality of components has been mounted is provided. This method comprises providing a cooling body, controlling a temperature of the cooling body, and positioning the heated carrier spaced apart from the cooling body using a plurality of supporting members. During operation the thermal conductivity of the plurality of supporting members, the thermal conductivity of the cooling body, the temperature of the cooling body, and the spacing between the cooling body and the heated carrier is configured to ensure that cooling of the heated carrier is predominantly obtained through thermal convection between the heated carrier and the cooling body.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1A illustrates a pick-and-place apparatus according to an aspect of the present disclosure, and figure 1B illustrates a method for arranging a semiconductor die on a lead-frame in accordance with an aspect of the present disclosure;
Figure 2 illustrates various views of a cooling stage in accordance with the present disclosure;
Figure 3 illustrates a further embodiment of a cooling body used in a cooling stage in accordance with an aspect of the present disclosure; and
Figure 4 illustrates various views of a further embodiment of a cooling stage in accordance with an aspect of the present disclosure.

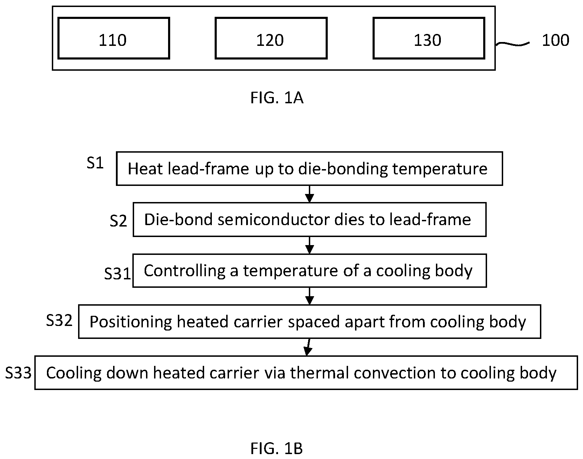

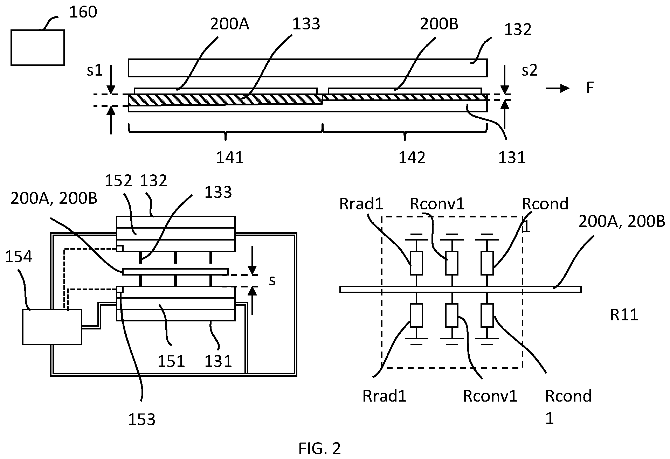

Figure 1A illustrates an embodiment of a pick-and-place apparatus 100 in accordance with an aspect of the present invention. Apparatus 100 comprises a heating stage 110 for heating a carrier, a pick-and-place unit 120 for picking an electrical component and for placing the picked electrical component on the heated carrier, and a cooling stage 130 for cooling down the heated carrier. Several embodiments of cooling stage 130 will be described referring to figures 2-4.
Figure 1B illustrates a method for arranging a semiconductor die on a lead-frame. In a first step S1, the lead-frame is heated up to a die-bonding temperature. In a next step S2, a plurality of semiconductor dies is die-bonded onto the lead-frame. Thereafter, the heated carried is cooled down in a cooling stage. The method for cooling down the heated carrier comprises a step S31 of providing a cooling body and controlling a temperature of the cooling body, a step S32 of positioning the heated carrier spaced apart from the cooling body using a plurality of supporting members, and a step S33 of allowing the heated carrier to cool down. During operation the thermal conductivity of the plurality of supporting members, the thermal conductivity of the cooling body, the temperature of the cooling body, and the spacing between the cooling body and the heated carrier is configured to ensure that cooling of the heated carrier is predominantly obtained through thermal convection between the heated carrier and the cooling body.
Figure 2, top, illustrates a cross section of an embodiment of a cooling stage 130 in accordance with the present disclosure. Here, cooling stage 130 comprises a first cooling body 131, a second cooling body 132, and a plurality of supporting members 133. Supporting members 133 support two heated lead-frames 200A, 200B and are elongated in a transport direction of lead-frames 200A, 200B, which is indicated by arrow F. Cooling stage 130 comprises a first section 141 and a second section 142. Supporting members 133 are elongated in the direction of arrow F and are rib, slat, or plate-like shaped.

Figure 2, bottom left, illustrates a cross section of cooling stage 130 that is perpendicular to the transport direction. Cooling body 131 comprises a duct 151 through which a coolant is fed by cooling unit 154. Cooling body 132 has a similar duct 152. Cooling bodies 131, 132 each comprise a temperature sensor 153. Cooling unit 154 is configured to control a temperature of cooling bodies 131, 132 in dependence of measurement data from these temperature sensors.

As shown, supporting members 133 keep carrier 200A, 200B spaced apart from cooling bodies 131, 132. This spacing is indicated using reference signs, s, s1, and s2. Furthermore, as shown in figure 1, top, spacing s1 decreases in the direction corresponding to arrow F. Moreover, in second section 142, a lower spacing applies than in first section 141 which is moreover constant in the second section.

Figure 2, bottom right, illustrates the thermal behavior of cooling stage 130. As shown, heated carrier 200A, 200B loses heat via radiation, represented by thermal resistors Rad1 and Rrad2, where the numeral indicates the first or second cooling body to which the heat is lost. They also lose heat by means of thermal convection through the air or other gaseous to cooling bodies 131, 132, as represented by thermal resistors Rconv1 and Rconv2. In addition, they lose heat by means of thermal conductance through supporting members 133 as represented by Rcond1 and Rcond2. According to an aspect of the present disclosure, Rcond1 >> Rconv1 and Rcond2 >> Rconv2, and Rrad1 >> Rconv1 and Rrad2 >> Rconv2. Accordingly, the thermal conductivity of supporting members 133, the thermal conductivity of cooling bodies 131, 132, the temperature of cooling bodies 131, 132, and spacing s between cooling bodies 131, 132 and heated carrier 200A, 200B is configured to ensure that during operation, cooling of heated carrier 200A, 200B is predominantly obtained through thermal convection between heated carrier 200A, 200B and cooling bodies 131, 132.

It should be noted that second cooling body 132 and the supporting members 133 in between second cooling body 132 and heated carrier 200A, 200B may be optional. Alternatively, the spacing between heated carrier 200A, 200B and second cooling body 132, which is constant in figure 1, may display the same behavior along the direction indicated by arrow F as the spacing between heated carrier 200A, 200B and first cooling body 131.

Cooling stage 130 comprises a conveying unit 160 which causes or guides heated carrier 200A, 200B to follow a path in the direction indicated by arrow F. Conveying unit 160 may be active in the sense that it actively propagates heated carrier 200A, 200B along the path. In other embodiments, conveying unit 160 is of the passive type, in which heated carrier 200A, 200B is guided, for example by engaging the sides of the heated carrier 200A, 200B that may have structures, such as holes, to facilitate such engagement.

In figure 2, heated carrier 200A is heated in first section 141 in a first cooling step. This step may follow the placement of a component. For example, a plurality of semiconductor dies may have been die-bonded onto heated carrier 200A, 200B. Directly after die-bonding, the temperature of heated carrier 200A, 200B is relatively high. Consequently, to prevent an excessive flow of thermal energy, a spacing between heated carrier 200A, 200B and cooling bodies 131, 132 is relatively large.

Heated carrier 200A, 200B is transported intermittently to first section 141 and second section 142. When a heated carrier 200A arrives in first section 141, a temperature of its forward end may be lower than that of its rearward end. Consequently, a lower value for the spacing can be chosen for cooling the forward end than for cooling the rearward end. In figure 2, this is achieved by varying a height of supporting member 133 along the path in first section 141. To allow the ends of supporting members 133 to lie in a same plane, cooling body 131 is shaped in an inclined manner. Here, it is noted that in the figure 2 embodiment, supporting members 133 are fixedly connected to cooling bodies 131, 132.

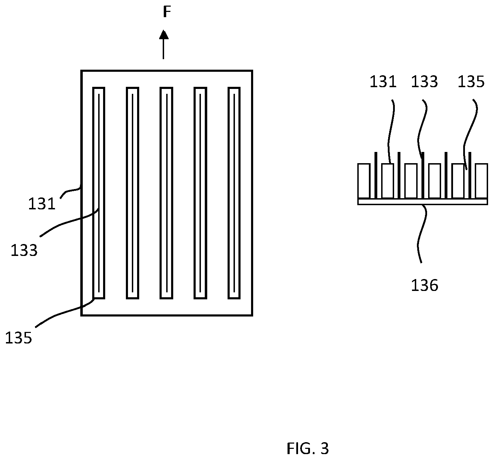

Figure 3, left, illustrates a top view of a different embodiment of cooling body 131 and supporting members 133, whereas figure 3, right, illustrates a corresponding cross section that is perpendicular to the direction indicated by arrow F. In this embodiment, cooling body 131 comprises slots 135 or other types of openings through which supporting members 133 extend. Both cooling body 131 and supporting members 133 may be connected, preferably releasably, to a base member 136.

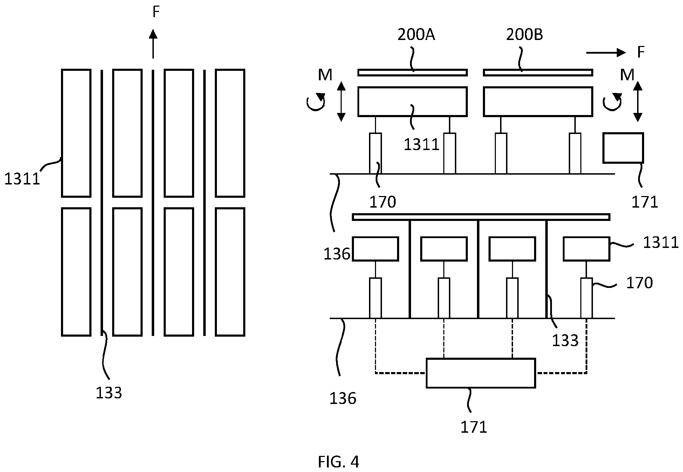

In figures 2 and 3, cooling body 131 comprises a single plate member. In other embodiments, cooling body 131 and/or cooling body 132 may comprises a plurality of cooling body parts. An example is shown in figure 4, left, in which cooling body 131 comprises eight cooling body parts 1311. Supporting members 133 extend in between the spaces between cooling body parts 1311.

Moreover, in figures 2 and 3, cooling body 131, 132 and supporting members 133 were stationary with respect to each other. In the embodiment shown in figure 4, right, cooling body parts 1311 are movable with respect to supporting members 133 and heated carriers 200A, 200B. To this end, hydraulic cylinders 170 are disposed at different positions along the path indicated by arrow F. Hydraulic cylinders 170 act as drives for moving cooling body parts 1311. By controlling cylinders 170 using controller 171, the connected cooling body part 1311 can be translated and rotated as indicated by arrows M. In this manner, cooling body part 1311 can be brough into an inclined position relative to heated carrier 200A. Hence, in the figure 2 embodiment, both supporting member 133 and cooling body 131 had to be adapted to allow for the varying spacing between heated carrier 200A and cooling body 131. In the figure 4, right, embodiment, a similar varying spacing can be achieved by actively positioning cooling body part 1311 while maintaining same supporting members 133.

In the embodiment above, hydraulic cylinders were used as examples of a drive for translating and rotating the cooling body or parts thereof. However, the present invention does not exclude other means for driving the cooling body or parts thereof. For example, actuation may also be realized using electric motors or pneumatic cylinders.

As shown in the cross section perpendicular to the direction indicated by arrow F, supporting members 133 can have a same height relative to base member 136 along the path.

By having cooling body 131 movably mounted relative to supporting members 133, it becomes possible to omit second section 142. For example, the second cooling step can be achieved by repositioning cooling body 131, or cooling body parts 1311, relative to supporting members 133 and heated carrier 200A, 200B. During the first cooling step, cooling body 131, or cooling body parts 1311, may have an inclined position relative to heated carrier 200A, and during the second cooling step, cooling body 131, or cooling body parts 1311, may be substantially parallel to heated carrier 200B and arranged closer to heated carrier 200B.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A cooling stage for cooling down a heated carrier on which a plurality of components has been mounted, comprising:
a cooling body;
a cooling unit for controlling a temperature of the cooling body;
a plurality of supporting members configured for supporting the heated carrier and for keeping the cooling body and heated carrier spaced apart;
wherein the thermal conductivity of the plurality of supporting members, the thermal conductivity of the cooling body, the temperature of the cooling body, and the spacing between the cooling body and the heated carrier is configured to ensure that during operation cooling of the heated carrier is predominantly obtained through thermal convection between the heated carrier and the cooling body.

2. The cooling stage according to claim 1, further comprising a conveying unit for conveying the heated carrier along a path from a start of the cooling stage to an end of the cooling stage, wherein the conveying unit is preferably configured to intermittently convey the heated carrier.

3. The cooling stage according to claim 2, wherein the cooling stage is configured to cool down the heated carrier during a first cooling step and a second cooling step following the first cooling step, wherein an average distance between the heated carrier and the cooling body is larger during the first cooling step than during the second cooling step.

4. The cooling stage according to claim 3, wherein during the first cooling step, the distance between the heated carrier and the cooling body decreases in a first direction from a start of the cooling stage to an end of the cooling stage, wherein during the second cooling step, the distance between the heated carrier and the cooling body preferably remains substantially constant in said first direction.

5. The cooling stage according to claim 4, wherein the cooling stage comprises a first section and a second section arranged downstream of the first section, wherein the conveying unit is configured for positioning the heated carrier in the first section during the first cooling step and for positioning the heated carrier in the second section during the second cooling step.

6. The cooling stage according to claim 5, wherein the conveying unit is configured to receive a next heated carrier when transferring the heated carrier from the first section to the second section, and to output a heated carrier that was previously arranged in the second section.

7. The cooling stage according to any of the previous claims, wherein the plurality of supporting members is fixedly connected to the cooling body, wherein in so far as depending on claim 5, a height in the first section of the plurality of supporting members in a second direction perpendicular to said first direction preferably decreases along the path and wherein the cooling body has an upper surface by which it is connected to the supporting members that is inclined relative to the heated carrier to compensate for the decreasing height of the supporting members.

8. The cooling stage according to any of the claims 1-6, wherein the cooling body is movable relative to the supporting members, wherein the plurality of supporting members is optionally fixedly connected to the conveying unit.

9. The cooling stage according to claim 8, further comprising a drive for moving the cooling body relative to the supporting members, the cooling stage preferably further comprising a controller for controlling the drive, wherein the controller is configured to control the drive to translate the cooling body, wherein the controller is preferably further configured for controlling the drive to rotate the cooling body around a rotation axis;
wherein the controller is preferably configured to control the drive to position the cooling body in a first position and first orientation relative to the heated carrier during the first cooling step, and to position the cooling body in a second position and second orientation relative to the heated carrier during the second cooling step.

10. The cooling stage according to claim 9, wherein the conveying unit is configured to maintain a same position of the heated carrier during the first cooling step and second cooling step.

11. The cooling stage according to any of the claims 8-10, wherein the cooling body comprises slots through which the supporting members extend.

12. The cooling stage according to any of the claims 8-11, wherein the cooling body comprises a plurality of cooling body parts, wherein, in so far as depending on claim 9, the controller is configured to control the drive for individually moving the cooling body parts.

13. The cooling stage according to any of the previous claims, wherein the cooling body comprises a plate member, and wherein the cooling unit comprises one or more ducts carrying a coolant for cooling the plate member, wherein the one or more ducts are at least partially integrated in or connected to the plate member, and/or
wherein the cooling unit is configured to control a temperature of the cooling body to be within a predefined range, and/or
wherein the heated carrier comprises a heated lead-frame, and/or
wherein the plurality of electrical components comprises a plurality of bare or packaged semiconductor dies, and/or wherein a temperature of the heated carrier prior to cooling by the cooling stage lies in a range between 150 and 450 degrees Celsius, and/or
wherein a temperature of the cooling body during operation is substantially constant, said substantially constant temperature preferably lying in a range between 18 and 35 degrees Celsius; and/or
wherein the cooling stage comprises a further cooling body that is arranged at an opposite side of heated carrier as the cooling body, wherein the cooling stage preferably comprises further supporting members extending between the further cooling body and the heated carrier, wherein the further cooling body and/or the further supporting members are configured as the cooling body and supporting members as defined in any of the previous claims, respectively.

14. A pick-and-place apparatus, comprising:
a heating stage for heating a carrier;
a pick-and-place unit for picking an electrical component and for placing the picked electrical component on the heated carrier;
the cooling stage according to any of the previous claims for cooling down the heated carrier.

15. A method for cooling down a heated carrier on which a plurality of components has been mounted, comprising:
providing a cooling body;
controlling a temperature of the cooling body;
positioning the heated carrier spaced apart from the cooling body using a plurality of supporting members;
wherein during operation, the thermal conductivity of the plurality of supporting members, the thermal conductivity of the cooling body, the temperature of the cooling body, and the spacing between the cooling body and the heated carrier is configured to ensure that cooling of the heated carrier is predominantly obtained through thermal convection between the heated carrier and the cooling body.
